Europäisches Patentamt

European Patent Office

Office européen des brevets

(19)

(11) Publication number: **0 173 188**
**A2**

## EUROPEAN PATENT APPLICATION

(21) Application number: **85110288.9**

(22) Date of filing: **17.08.85**

(51) Int. Cl.⁴: **H 01 L 21/48, H 01 L 21/98**

(30) Priority: **29.08.84 US 645576**

(43) Date of publication of application: **05.03.86 Bulletin 86/10**

(84) Designated Contracting States: **DE FR GB**

(71) Applicant: **International Standard Electric Corporation, 320 Park Avenue, New York New York 10022 (US)**

(72) Inventor: **Landis, Richard Charles, 436 Huntington Street, Shelton, Ct 06484 (US)**

(74) Representative: **Morstadt, Volker, Dipl.-Ing., c/o Deutsche ITT Industries GmbH Patent/Lizenzabteilung Postfach 840 Hans-Bunte-Strasse 19, D-7800 Freiburg/Brsg. (DE)**

(54) **Photo-thick-film-hybrid process.**

(57) A thick film process for making a hybrid electronic circuit is disclosed which employs the direct application of a photo mask to a substrate. A paste is disposed through appropriate channels of the photo mask and cured. Then the photo mask is removed leaving a preselected pattern of conductive or non-conductive lines on the substrate. This method may be used for generating a network of very thin, closely spaced lines having a controlled cross-section, while eliminating the formation of undesirable shorts or leakage paths.

## PHOTO-THICK FILM HYBRID PROCESS

BACKGROUND OF THE INVENTION

1. Field of Invention

This invention pertains to a process for forming a preselected conducting or non-conducting pattern of lines on a hybrid substrate.

2. Description of the Prior Art

Typically a preselected pattern of conductive lines was screen printed on a substrate by the following process: first a mask was generated with open channels or areas corresponding to the desired pattern. The mask was then applied to the bottom surface of a wire mesh and the mesh was laid on the substrate. Finally a thick paste was disposed on top of the mesh and then forced through and then cured to form the printed pattern. A description of the process and the various materials used therein can be found in Lewis F. Miller's "Thick Films Technology and Chip Joining", Gordon and Breach, New York 1972.

However, as the demand for narrower lines (in the order of 5 mils or less) and more complex patterns evolved, it was discovered that patterns formed by said method with closer lines yielded unacceptable results. For example it was found that lack of sufficient definition between lines caused leakage and short currents if the lines were conducting. Also a close spacing between the lines requires a very fine or thin mask which, frequently had insufficient surface adhesion to stick to the screen. As a result the mask frequently separated, at least partially, from the screen. This latter effect was enhanced by the flexing or bending of the screen during the printing cycle. Finally, as the line width approached the diameter of the wires or monofilaments which made up the screen, these wires tended to block the paste thereby disrupting uniform paste depositions.

OBJECTIVES AND SUMMARY OF THE INVENTION

In view of the above, it is a principal objective of this invention is to provide a method of forming a preselected pattern of narrow lines on a substrate having a close spacing.

A further objective is to provide a printing method which overcomes the problems associated with masks partially adhering to the screen.

Yet a further objective is to provide a printing method which results in lines with a uniform cross-section.

Other objectives and advantages of the invention shall become apparent in the following description of the invention. In accordance with this invention, a preselected pattern of lines is generated on a substrate by providing a mask having a plurality of slots and or channels corresponding to said pattern, laying the mask on the substrate, applying a paste to the mask and substrate, curing the paste and removing the mask.

BRIEF DESCRIPTION OF THE DRAWINGS

Figure 1 shows the elements of the silk printing method as taught by the prior art;

Figure 2 shows the penetration of paste through the screen and mask, according to the prior art method of Figure 1;

Figure 3 shows a cross-section of substrate with a pattern formed in accordance with the prior art method of Figures 1 and 2;

Figures 4-6 shows how a mask is formed on a substrate in accordance with the present invention;

Figures 7-8 shows the application of paste to the mask and substrate; and

Figure 9 shows a cross-sectional view of a substrate with a line pattern generated in accordance with the present invention.

DETAILED DESCRIPTION OF THE INVENTION

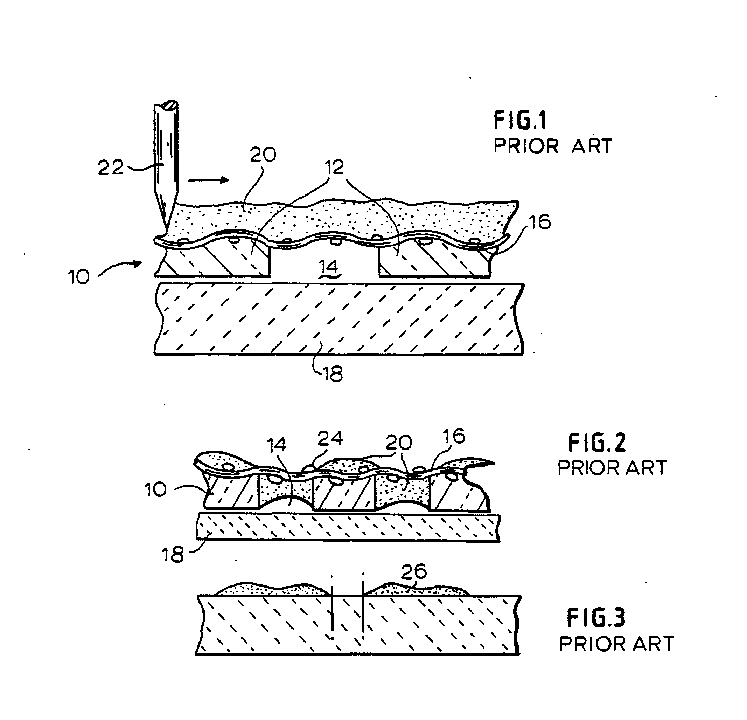

In order to impart a better appreciation of the invention, the prior art method of making hybrid electronic circuits by the screen printing process is first described. As shown in Figure 1, a mask 10 having members 12 defining slots or channels 14 is first applied to and glued on a woven screen 16. Next, the screen is placed on the surface of a substrate 18 with mask 10 positioned between the screen and substrate as shown. A paste 20 is disposed on the screen and the channels 14 of the mask by a squeegee or doctor blade 22. The results of this operation are shown in Figure 2.

The screen and mask are then removed leaving the paste shaped in the desired pattern as shown in Figure 3. It is obvious from this description that the screen and mask are moved several times and if the mask, and more particularly members 12 have insufficient surface areas contacting the screen, the mask will separate from the screen. Furthermore as is apparent from Figure 2 if the width of channels 14 is in the same order of magnitude as the diameter of the wires 24 of screen 16, these wires block some of the paste so it cannot flow smoothly and evenly into channels 14.

As shown in Figure 3, after the mask and screen are removed and prior to the curing of the paste, lines 26 have a tendency to slump decreasing the spacing in between adjacent lines. As a result it is more likely that shorts or leakage paths are formed between adjacent lines. Furthermore since the overall height or thickness of the lines 26 is reduced, the electric resistivity of the respective lines increases. This effect in turn not only decreases the current-carrying capacity of the line but causes the line to heat up more thereby increasing the overall temperature of the hybrid circuit.

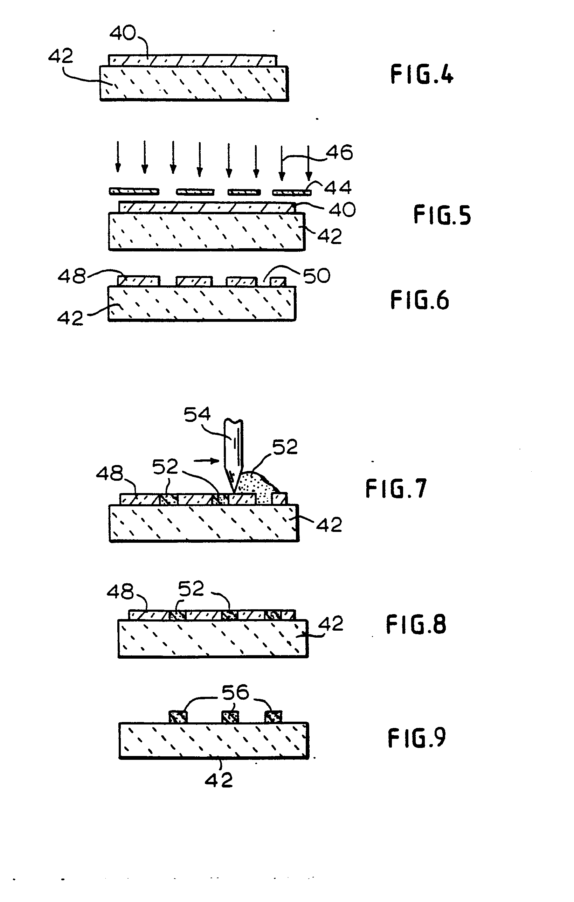

According to the present invention a predetermined pattern of lines is formed on a substrate as follows. A sheet of an appropriate photomask material 40 is applied to a substrate 42 as shown in Figure 4. Next, a photo artwork 44 is placed on the mask. A suitable radiation 46 (Figure 5) such as visible light is directed through the artwork 44 at mask 40, after which the undesirable portions of the mask are developed and washed away to leave a plurality of mask members 48 defining channels 50.

Once the mask members 48 are formed, a paste 52 is applied to the mask and then forced into channels 50 with a squeegee 54. (See Figure 7). Once all the channels are filled with paste (Figure 8), the paste is precured by heating or other suitable means to remove the volatile components of the paste. Importantly the mask members 48 are still in place thus insuring that the paste is not allowed to slump.

Finally the mask is removed by firing the assembly of Figure 8. What remains is a substrate 42 with a plurality of lines 56 disposed in the preselected pattern. The method of forming and removing a photomask is well known in the art and need not be described in greater detail.

By using the above described method, a plurality of lines were formed on a substrate which had a width of 1.8 mils and a spacing of 1.2 mil (i.e. the lines were spaced 3 mils. center-to-center). The masking sheet comprised a dry laminate photo film 1/2 mil thick commercially known as "3M-RESOLVE" and available from the Minnesota Mining and Manufacturing Company. Since conductive lines were desired, the paste used for the above-mentioned spacing was a standard silver conductive paste used in normal thick-film hybrid manufacture, which when fired at 800°C produces an electrically conductive line. Advantageously the conductive line may be solder-connected to various electronic components. The paste may be any one of the following products manufactured by the DuPont Company: No. 6190 Ag; . No. 9770 Ag/Pt; and No. 9755 Ag/Pd/Pt.

Obviously numerous modifications may be made to the method described herein without departing from the scope of the invention as set forth in the appended claims.

I claim:

1. A method for depositing a preselected pattern of lines on a substrate to form a hybrid electronic device comprising:

    providing a mask having channels corresponding to said preselected pattern on said substrate;

    depositing a paste on the mask and forcing said paste to fill up said channels; and

    removing the mask.

2. The method of claim 1 wherein said mask is removed by firing the mask, paste and substrate.

3. The method of claim 1 wherein said paste is precured prior to removing said mask.

4. The method of claim 1 wherein the step of providing a mask comprises the steps of: applying an appropriate film mask material to said substrate; superimposing a photographic art work corresponding to said channels on the mask; directing radiation through said art work to the film mask; and removing portions of the film mask corresponding to said channels.

0173188

1/2

FIG.1
PRIOR ART

FIG.2
PRIOR ART

FIG.3
PRIOR ART

FIG.4

FIG.5

FIG.6

FIG.7

FIG.8

FIG.9